# EUROPEAN PATENT APPLICATION

(11) **EP 4 530 655 A1**
(43) Date of publication of application: **02.04.2025**
(21) Application number: 23200400.2
(22) Date of filing: 28.09.2023
(51) Int. Cl.: G01R 33/3815, H01R 4/68, H01R 4/46, H01R 4/58

(54) **CONNECTOR FOR A CONNECTOR SYSTEM OF A MAGNETIC RESONANCE EXAMINATION APPARATUS**

(71) Applicant: Koninklijke Philips N.V., 5656 AG Eindhoven (NL)
(72) Inventor: FORTHMANN, Peter, Eindhoven (NL); VERNICKEL, Peter, Eindhoven (NL); LIPS, Oliver, 5656AG Eindhoven (NL)
(74) Representative: Philips Intellectual Property & Standards

(57) **Abstract**

According to the invention, a connector (2) for a connector system (24) of a magnetic resonance examination apparatus (26), comprising a lug (1) and a superconductor line (12), the lug (1) comprising a metallic contact element (17) with a contact surface (18) and a terminal (14), wherein the metallic contact element (17) further comprises a recess or depositon area (16) in which a superconductor (10) is arranged in galvanic contact with the metallic contact element (17), wherein the superconductor (10) is galvanically connected to the terminal (14), and the superconductor line (12) is connected to the terminal (14) such that the superconductor line (12) is galvanically connected to the superconductor (10). In this way, an improved connector that reduces heat dissipation in a connector system for a magnetic resonance examination apparatus is provided.

## Description

### FIELD OF THE INVENTION

The invention relates to the field of magnetic resonance imaging. In particular, the present invention relates to the field of a connector for a connector system of a magnetic resonance examination apparatus.

### BACKGROUND OF THE INVENTION

A magnetic resonance examination apparatus uses a main magnetic field to align the nuclear spins of atoms. This main magnetic field is generated by a superconducting static field magnet in a cryostat in the magnetic resonance examination apparatus. Herein, magnetic resonance examination apparatuses include magnetic resonance imaging apparatuses primarily intended for diagnostic imaging on a patient and nuclear magnetic resonance apparatuses.

To generate the main magnetic field, the static field magnet and thus the cryostat must be supplied with a current. This current can be provided by an external power supply which is galvanically connected to the static field magnet inside the cryostat of the magnetic resonance examination apparatus. To maintain superconductivity of the static field magnet, the cryostat must maintain the temperature required for superconductivity, which for common static field magnets is 4 K for niobium titanium (NbTi) superconductors or 20 K for magnesium diboride (MgB₂) superconductors. In the case of NbTi this temperature is usually achieved employing liquid helium as a coolant. The MgB₂ superconductor is preferably a dry magnet, which essentially does not require a coolant. However, liquid helium for the NbTi superconductor, as well as the power to maintain the temperature of the dry magnet, are valuable resources whose loss must be avoided by the heat introduced into the cryostat. The cryostat, however, as already mentioned, must be supplied with the power necessary to operate the static field magnet via an external power supply. This external power supply is provided via a connector extending from the cryostat with a connector corresponding to the connector, to which current is applied on the room temperature side. In the present case, the corresponding connector is a connector that is designed in such a way that it can be connected to the connector in a galvanically conductive manner.

The cryostat has a multi-stage refrigeration system comprising several stages of refrigerators for generating the temperature required for superconductivity. With the connector and the corresponding connector, a cold stage, which is for example a second refrigerator stage, can be galvanically conductively contacted with a warmer stage, which is for example a first refrigerator stage having a room temperature. However, a connector system formed in this way creates a thermal bridge from the room temperature side outside the cryostat into the cryostat. This temperature gradient leads to a static heat flow that stresses the cryostat. Similarly, Joule heating occurs due to the flowing currents in the connector system.

From WO 2013/114233 A1 a magnetic resonance imaging system comprising a superconducting magnet with a first current lead and a second current lead for connecting to a current ramping system is known. The magnet further comprises a vacuum vessel penetrated by the first current lead and the second current lead. The magnet further comprises a magnet circuit within the vacuum vessel. The magnet circuit has a first magnet circuit connection and a second magnet circuit connection. The magnet further comprises a first switch between the first magnet connection and the first current lead and a second switch between the second magnet connection and the second current lead. The magnet further comprises a first current shunt connected across the first switch and a second current shunt connected across the second switch.

Both the connector and the corresponding connector are regularly made of copper, and the contacting parts of the connectors are often provided with lugs, so that the connected connectors also exhibit heating due to the contact resistance of the copper.

### SUMMARY OF THE INVENTION

It is an object of the invention to provide an improved connector that reduces heat dissipation in a connector system for a magnetic resonance examination apparatus.

According to the invention, this object is addressed by the subject matter of the independent claims. Preferred embodiments of the invention are described in the dependent claims.

Therefore, according to the invention, a connector for a connector system of a magnetic resonance examination apparatus, comprising a lug and a superconductor line, the lug comprising a metallic contact element with a contact surface and a terminal, wherein the metallic contact element further comprises a recess or a depositon area on the metallic contact element's surface in or on which a superconductor is arranged in galvanic contact with the metallic contact element, wherein the superconductor is galvanically connected to the terminal, and the superconductor line is connected to the terminal such that the superconductor line is galvanically connected to the superconductor.

The contact surface of the metallic contact element is used to connect it galvanically to a corresponding contact surface of a corresponding contact element of a corresponding lug of a corresponding connector. With the corresponding connector, an external power supply is thus applicable to the connector. More specifically, the external power supply is applied to the contact surface of the connector with the metallic contact element and the superconductor fitted in the recess. The superconductor is typically soldered to the metallic contact element. Because the contact element is metallic, it is particularly suitable for galvanic and thermal conduction.

Preferably, metals with the lowest possible oxygen content are used for the metallic contact element. This metal should also have a high conductivity in order to reduce the resistance and the associated heating. Suitable metals are accordingly, for example, copper or silver.

The superconductor makes galvanic contact with the metallic contact element, which in the case of the superconductor also implies thermal contact. Thus, the metallic contact element, the contact surface as well as the corresponding contact surface are cooled, which counteracts the Joule heat.

The terminal allows the lug to be galvanically and thermally connected to the superconductor line, so that the superconductor formed in the lug is galvanically and thermally connected to the superconductor line. That is, the superconductor line ensures that the superconductor in the lug is kept at a superconducting temperature by thermal conduction. The external power supply, on the other hand, is transmitted with the superconductor to the superconductor line for further use in the magnetic resonance examination apparatus.

To protect the superconductor line, it can be surrounded by an electrical lead which can also be thermally and galvanically connected to the terminal. The superconductor line is then arranged or formed within the electrical lead. The electrical lead can be used to limit temperature loss of the superconductor line and mechanical stress on the superconductor line.

The superconductor line is preferably a superconductor tape which preferably comprises two key features: A superconducting compound (usually in the form of filaments/coating), and a conduction stabilizer, which carries the current in case of the loss of superconductivity (known as quenching) in the superconducting material.

In principle, it is possible to design the metallic contact element in various ways. According to a preferred embodiment of the invention, however, the recess or depositon area extends to the contact surface and the superconductor is arranged in galvanic contact with the metallic contact element in such a way that the outward surface of the superconductor is flat with the contact surface of the metallic contact element.

In this case, the contact surface of the contact element in conjunction with the outward surface of the superconductor is used to connect it galvanically to the corresponding contact surface. The external power supply here is applied to the contact surface of the metallic contact element and the outward surface of the superconductor fitted in the recess or on the depositon area . The superconductor is fitted in the recess or on the depositon area in such a way that the outward surface of the superconductor is flush with the contact surface. In the present case, outward surface means the surface of the superconductor facing the corresponding contact surface as part of the contact surface.

The cooling effect here for the corresponding contact surface is intensified considerably by the direct contact with the outward surface, counteracting Joule heating directly at the junction of the contacting surfaces. Similarly, this enables resistance-free transmission of the external power supply immediately from the moment it enters the outward surface.

The flat contact surface with the superconductor forming the flat outward surface is particularly suitable in this case because a contact increases in inverse proportion to the area of the contact. At the same time, a pressure between the contact surface and the corresponding contact surface can be reinforced with screws or bolts, which further reduces the contact resistance. Whereby flat in the present case means flat on a macroscopic level.

The special design of this lug allows to connect the external power supply without it entering the connector through a normal, resistive conductor such as copper. Instead, the connector according to the invention enables the direct galvanic connection of the superconductor with the corresponding connector.

In principle, the superconductor and the superconductor line can be configured in different ways. According to a preferred embodiment of the invention, however, the superconductor and/or the superconductor line is a high-temperature superconductor. Even further preferred here is that the high-temperature superconductor is a magnesium diboride superconductor. Nevertheless, it may also be provided that the superconductor tape is a rare-earth barium copper oxide (ReBCO) superconductor. The ReBCO high-temperature superconductor tape conducts electricity with zero electrical resistance and can be manufactured in flexible, long lengths. The advantage of using a high-temperature superconductor is that it can be conduction-cooled, unlike NbTi superconductors, for example, which must always be surrounded by liquid helium. This avoids the need to introduce liquid helium into the connector to keep it at the superconducting temperature.

In principle, it is possible to form the metallic contact element in various ways. According to a preferred embodiment of the invention, however, the metallic contact element comprises at least one through-hole. Preferably, the extension of the through-hole is perpendicular to the contact surface. With the through-hole, screws or other fasteners can be employed to connect the lug to the corresponding lug.

It is possible that the superconductor forms different sized portions of the contact surface. According to a preferred embodiment of the invention, however, the superconductor is only formed in an area outside of the through-hole. This ensures the greatest possible contact between the superconductor and the corresponding contact surface without sacrificing the integrity of the lug.

In general, the superconductor can be connected to the superconductor line in different ways. According to a preferred embodiment of the invention, however, the superconductor line is integrally formed with the superconductor. In this situation, the term "terminal" only relates to the transition of the superconductor in the recess or on the depositon area to the superconductor line without having a connection function in the sense of connecting and disconnecting the superconductor line from the superconductor in the recess or on the depositon area . Therefore, there is no separate superconductor in the recess or on the depositon area . Rather, the superconductor of the superconductor tape and the superconductor in the recess or on the depositon area are designed as one single piece. In other words: the superconductor line extends into the recess or depositon area of the lug. This allows improved transferability of cooling and external power supply transmission.

The invention further concerns a connector system for the magnetic resonance examination apparatus with a connector according to the above and a corresponding connector which comprises an electrical lead which is galvanically connected to a corresponding lug of the corresponding connector, wherein the corresponding lug of the corresponding connector is galvanically connected to the lug of the connector. Accordingly, the corresponding contact element can be formed in different ways. However, according to a preferred embodiment of the invention, the corresponding contact element of the corresponding lug of the corresponding connector comprises a through-hole in the corresponding contact surface through which the lug is connectable to the corresponding lug , wherein the through-hole in the corresponding contact surface of the corresponding lug coincides with the through-hole of the lug when the connector is brought together with the corresponding connector, so that the corresponding connector can be connected to the connector with a bolt or a screw.
Further, according to the invention, a magnetic resonance examination apparatus comprising a connector system as described above. It is possible to employ the connector system in different ways in the magnetic resonance examination apparatus. According to a preferred embodiment of the invention, however, the magnetic resonance examination apparatus further comprises a cryostat comprising at least one coil arranged within the cryostat, wherein the electrical lead is galvanically connected to the coil in the cryostat, wherein the superconductor line is cooled employing the cryostat, and external power is supplied to the coil with the connector system. In this way, temperature losses in the magnetic resonance examination apparatus are reduced and the transmission of an external power supply is improved.

It is possible to connect coils in the cryostat in various ways. According to a preferred embodiment of the invention, however, the cryostat comprises at least two coils galvanically connected to each other with the connector system. Similarly, the connector system can be used to route the power supply from a central power supply line to the individual coils to decouple the thermal and galvanic conduction in the superconductor. In this way less heat is transferred.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a connector system with a connector according to a preferred embodiment of the invention,
Fig. 2 schematically depicts the connector system with the connector according to another preferred embodiment to the invention; and
Fig. 3 schematically depicts a magnetic resonance examination apparatus with the connector system.

### DETAILED DESCRIPTION OF EMBODIMENTS

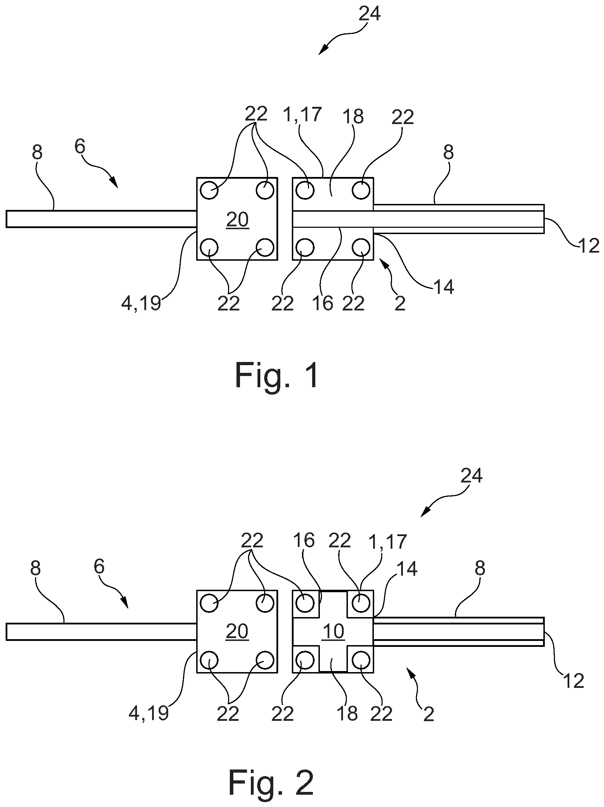

Fig. 1 schematically depicts a connector system 24 with a connector 2 according to a preferred embodiment of the invention. The connector 2 has an electrical lead 8 with a superconductor line 12, which extends via a terminal 14 into a recess 16 in a lug 1. A contact surface 18 of a metallic contact element 17 of the lug 1 has the same recess 16. An outward surface is formed with the superconducting line 12, which together with the contact surface 18 makes galvanic contact with a corresponding contact surface 20 of a corresponding contact element 19 of a corresponding lug 4 of a corresponding connector 6. The corresponding connector 6 also has an electrical lead 8 to which an external power supply can be applied. The lug 1 and the corresponding lug 4 are provided with through-holes 22, which enable the two lugs 1, 4 to make galvanic contact with each other.

Fig. 2 schematically depicts the connector system with the connector according to another preferred embodiment to the invention. In the present lug 1, the recess or the depositon area 16 extends over a large part of the contact surface 18 of the metallic contact element 17. Only the through-holes 22 are excluded. A superconductor 10 is formed in this recess or depositon area 16 with its outward surface flush with the contact surface 18, providing a flat surface for contacting the corresponding contact surface 20. The superconductor 10 is connected to the terminal 14 and is galvanically and thermally contacted with the superconductor line 12 from the side of the electrical line 8.

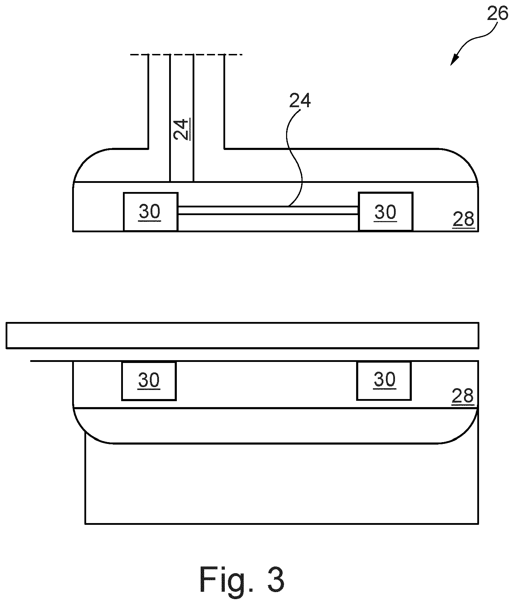

Fig. 3 schematically depicts a magnetic resonance examination apparatus 26 with two connector systems 24. Here, one connector system 24 is used to power coils 30 arranged within the cryostat 28 of the magnetic resonance examination apparatus 26. The other connector system 24 is employed for galvanically connecting the two coils 30 within the cryostat 28.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| Lug | 1 |
| connector | 2 |
| corresponding lug | 4 |
| corresponding connector | 6 |
| electrical lead | 8 |
| superconductor | 10 |
| superconductor line | 12 |
| terminal | 14 |
| recess or depositon area | 16 |
| metallic contact element | 17 |
| contact surface | 18 |
| corresponding contact element | 19 |
| corresponding contact surface | 20 |
| through-hole | 22 |
| connector system | 24 |
| magnetic resonance examination apparatus | 26 |
| cryostat | 28 |
| coil | 30 |

## Claims

1. Connector (2) for a connector system (24) of a magnetic resonance examination apparatus (26),
comprising a lug (1) and a superconductor line (12),
the lug (1) comprising a metallic contact element (17) with a contact surface (18) and a terminal (14), wherein
the metallic contact element (17) further comprises a recess or a depositon area on the metallic contact element's surface (16) in which a superconductor (10) is arranged in galvanic contact with the metallic contact element (17), wherein
the superconductor (10) is galvanically connected to the terminal (14), and
the superconductor line (12) is connected to the terminal (14) such that the superconductor line (12) is galvanically connected to the superconductor (10).

2. Connector (2) according to claim 1, wherein the recess or the depositon area (16) extends to the contact surface (18) and the superconductor (10) is arranged in galvanic contact with the metallic contact element (17) in such a way that the outward surface of the superconductor (10) is flat with the contact surface (18) of the metallic contact element (17).

3. Connector (2) according to claim 1 or 2, wherein the superconductor (10) and/or the superconductor line (12) is a high-temperature superconductor.

4. Connector (2) according to any one of the claims claim 1 to 3, wherein the metallic contact element (17) comprises at least one through-hole (22).

5. Connector (2) according to claim 4, wherein the superconductor (12) is only formed in an area outside of the through-hole (22).

6. Connector (2) according to any one of the preceding claims, wherein the superconductor line (12) is integrally formed with the superconductor (10).

7. Connector system (24) for the magnetic resonance examination apparatus (26) with a connector (2) according to any one of the claims 1 to 6 and a corresponding connector (6) which comprises an electrical lead (8) which is galvanically connected to a corresponding lug (4) of the corresponding connector (6), wherein the corresponding lug (4) of the corresponding connector (6) is galvanically connected to the lug (1) of the connector (2).

8. Magnetic resonance examination apparatus (26) comprising a connector system (24) according to claim 7.

9. Magnetic resonance examination apparatus (26) according to claim 8, with a cryostat (28) comprising at least one coil (30) arranged within the cryostat (28), wherein the electrical lead (8) is galvanically connected to the coil (30) in the cryostat (28), wherein the superconductor line (12) is cooled employing the cryostat (28), and external power is supplied to the coil (30) with the connector system (24).

10. Magnetic resonance examination apparatus (26) according to claim 8 or 9, wherein the cryostat (28) comprises at least two coils (30) galvanically connected to each other with the connector system (24).
